# EUROPÄISCHE PATENTSCHRIFT

(11) **EP 1 621 053 B1**
(45) Veröffentlichungstag und Bekanntmachung des Hinweises auf die Patenterteilung: **02.01.2013**
(21) Anmeldenummer: 04730954.7
(22) Anmeldetag: 04.05.2004
(51) Int. Cl.: H05K 3/10, H05K 3/46, H05K 1/00, H01R 3/00

(54) **Verfahren zur Herstellung eines elektronischen Bauteils**
Method for manufacturing an electronic element
Méthode pour la fabrication d'un élément électronique

(30) Priorität: 05.05.2003 DE 10320090
(43) Veröffentlichungstag der Anmeldung: 01.02.2006
(73) Patentinhaber: Infineon Technologies AG, 85579 Neubiberg (DE)
(72) Erfinder: BAUER, Michael, 93152 Nittendorf (DE); BEMMERL, Thomas, 92421 Schwandorf (DE); FINK, Markus, 93199 Zell (DE); FÜRGUT, Edward, 86453 Dasing (DE); GRÖNINGER, Horst, 93142 Maxhütte-Haidhof (DE); VILSMEIER, Hermann, 85757 Karlsfeld (DE)
(74) Vertreter: Schäfer, Horst
(86) Internationale Anmeldenummer: PCT/DE2004/000935
(87) Internationale Veröffentlichungsnummer: WO 2004/100628

(56) Entgegenhaltungen:
- EP-A- 1 124 264
- EP-A2- 0 288 807
- WO-A2-02/48432
- DE-A- 19 715 898
- US-A- 3 390 012
- US-A- 4 694 138
- PATENT ABSTRACTS OF JAPAN Bd. 2002, Nr. 05, 3. Mai 2002 (2002-05-03) -& JP 2002 008451 A (MISHIMA RYOJI), 11. Januar 2002 (2002-01-11)
- H-K ROTH ET AL: "Laser recording of circuit structures from conducting polymers in insulating polymer layers" CIRCUIT WORLD, XX, XX, Bd. 2, Nr. 22, 1996, Seiten 31-32, XP002076935 ISSN: 0305-6120
- BANKS R H ET AL: "Laser Generated Conductive Lines" IBM TECHNICAL DISCLOSURE BULLETIN, IBM CORP. NEW YORK, US, Bd. 19, Nr. 3, 1. August 1976 (1976-08-01), Seite 1014, XP002187264 ISSN: 0018-8689
- Friedrich Beck: "Integrierte Halbleiterschaltungen", 1993, VCH Verlag ISBN: 3-527-28410-9 pages 219-220, * page 219 - page 220 *
- IAN SAMPLE: "There's gold in them there roots", NEWSCIENTIST, [Online] no. 2332, 2 March 2002 (2002-03-02), Retrieved from the Internet: URL:http://www.newscientist.com/article/mg 17323323.000-theres-gold-in-them-there-roo ts.html>
- KURT KLEINER, JENNY HOGAN: "How safe is nanotech?", , [Online] no. 2388, 29 March 2003 (2003-03-29), Retrieved from the Internet: URL:http://www.newscientist.com/article/mg 17723880.900-how-safe-is-nanotech.html>
- Hans-Jürgen Hacke: "Montage Integrierter Schaltungen", 1987, Springer-Verlag ISBN: 3-540-17624-1 pages 128-133,
- Oberbach, Baur, Brinkmann, Schmachtenberg: "Saechtling Kunststoff Taschenbuch", 2004, Carl Hander Verlag ISBN: 3-446-22670-2 page 594,
- "Schnellabbindender Epoxy-Klebstoff" In: "RS Bedienungsanleitung", March 2001 (2001-03), RS page V8809,

## Beschreibung

Die Verdrahtung und Verpackung von elektrischen Komponenten und/oder Halbleiterchips zu kompakten elektrischen Bauteilen ist äußerst komplex und aufwendig. So sind Außenkontakte vorzusehen, die über mehrere Verdrahtungslagen oder Mehrlagensubstrate mit Elektroden der elektrischen Komponenten und/oder mit Kontaktflächen von Halbleiterchips zu verbinden sind. Zwischen den Verdrahtungslagen beziehungsweise in den Mehrlagensubstraten sind Durchkontakte vorzusehen, um die Leiterbahnen der unterschiedlichen Lagen über diese Durchkontakte elektrisch miteinander zu verbinden. Die Herstellung derartig aufgebauter elektrischer Bauteile ist somit aufwendig und kostenintensiv.

Im Stand der Technik sind solche Verfahren aus den Druckschriften EP 0 288 807 A2 und WO 02/48432 A2 bekannt.

Die US 4, 694, 138 offenbart ein Verfahren zum Herstellen einer Leiterbahn. Ein isolierendes Material aus einem Polymer und eine Metallquelle wird bereitgestellt. Ein Bereich der Oberfläche wird selektiv entlang einem vorbestimmten Muster aufgewärmt, wobei das Polymer aufgedampft und das Metall geschmalzen wird, um eine Leiterbahn aus Metall zu bilden.

Aufgabe der Erfindung ist es, ein Verfahren zur Herstellung eines elektrischen Bauteils anzugeben.

Gelöst wird diese Aufgabe mit dem Gegenstand des unabhängigen Anspruches. Vorteilhafte Weiterbildungen der Erfindung ergeben sich aus den abhängigen Ansprüchen.

Ein elektrisches Bauteil weist mindestens eine elektrische Komponente auf, die elektrische Anschlüsse besitzt. Darüber hinaus weist das elektrische Bauteil einen Leitungsbereich aus Kunststoff mit Leitungen auf, die karbonisierten Kunststoff und/oder agglomerierte Nanopartikel haben. Diese Leitungen stehen mit elektrischen Anschlüssen und/oder mit Außenanschlüssen des elektrischen Bauteils in Verbindung.

Ein Vorteil dieses elektrischen Bauteils ist es, dass dreidimensionale Verdrahtungen zwischen zu verdrahtenden Elektroden von elektrischen Komponenten und/oder Kontaktflächen von Halbleiterchips mit Außenkontakten des elektrischen Bauteils realisierbar sind, ohne dass in dem elektrischen Bauteil aufwendige Umverdrahtungslagen oder Mehrlagensubstrate vorzusehen sind. Vielmehr kann der Leitungsbereich aus Kunststoff mit karbonisierten Leitungen dreidimensional gestaltet sein. Sowohl senkrecht verlaufende als auch wagerecht verlaufende Leitungen, sowie Leitungen unter jedem gewünschten Raumwinkel sind möglich, so dass effektive und kurze Verdrahtungsstrecken in dem Bauteil mit Hilfe der Leitungsbereiche realisiert werden können. Damit können Laufzeitverzögerungen innerhalb des elektrischen Bauteils vermindert werden, die Leitungsführungen dreidimensional geplant werden und durch spiralförmiges oder durch flächiges Ausbilden der Leitungen können passive, kapazitive oder induktive Komponenten in dem Leitungsbereich eingebaut werden.

Die Karbonisierung des Kunststoffes zu Leitungen in einem Leitungsbereich wird durch Zufuhr von Energie unter lokal begrenzter Verkokung des Kunststoffes realisiert. Ein Ausrichten und ein Agglomerieren von Nanopartikeln zu Leitungen kann durch Anlegen von elektromagnetischen Wechselfeldern oder über Mikrowellenanregung erfolgen. Abhängig von dem Material der Nanopartikel können derartige Anregungen zu einer anisotropen Ausrichtung der isotrop im Kunststoff verteilten Nanopartikel bis hin zu einem Zusammensintern der Nanopartikel zu Leitungen in dem Kunststoff führen. Darüber hinaus sind auch Leitungen aus zunächst nicht verbundenen Nanopartikeln oder Agglomeraten von Nanopartikeln mit Brücken aus karbonisierten Abschnitten zwischen den Agglomeraten oder den Nanopartikeln für das elektrische Bauteil vorgesehen.

Welcher Leitungstyp in dem Bauteil überwiegt hängt einerseits von der Menge der Zugabe an Nanopartikeln und andererseits von der Art der Energiezufuhr durch elektromagnetische Anregung oder durch Wärmestrahlung, sowie von den Eigenschaften des Kunststoffes ab. Je höher der Vernetzungsgrad einer die Leiterbahnen umgebenden Harzschicht ist, umso stabiler ist eine Leiterbahnführung möglich. Dazu kann die direkt an die Leitung angrenzende Harzschicht beim Karbonisieren angehärtet oder ausgehärtet sein, so dass die "Rußleitung" mechanisch stabilisiert ist. Der Übergang zu den Außenanschlüssen des elektronischen Bauteils kann dadurch erreicht werden, dass die Enden der karbonisierten Leitungen metallisiert sind.

Eine Vorrichtung zur Herstellung eines elektrischen Bauteils mit mindestens einer elektrische Anschlüsse aufweisenden Komponente weist eine Gießform zum Einbringen von Kunststoff auf. In die Gießform ist wenigstens eine elektrische Komponente einsetzbar. Die Gießform kann von einem flachen Gefäß gebildet sein, auf dessen flachem Boden mehrere elektrische Komponenten, wie passive Bauelemente und/oder Halbleiterchips angeordnet werden können, bevor ein Einbringen von Kunststoff in die Gießform erfolgt. Zusätzlich zu der Gießform weist die Vorrichtung mindestens eine fokussierbare Energiequelle mit einer Ausrichtmechanik zum Führen des Fokussierbereiches der Energiequelle in Leitungsbereichen des eingebrachten Kunststoffes auf. Diese fokussierbare Energiequelle dient zur Bildung von Leitungen des herzustellenden elektrischen Bauteils. Weiterhin weist die Vorrichtung eine Gießvorrichtung zum kontinuierlichen oder schichtweisen Auffüllen der Gießform mit Kunststoff unter Einbetten der Komponenten und unter Bilden von Verbindungsleitungen in Leitungsbereichen des Kunststoffs auf.

Eine derartige Vorrichtung hat den Vorteil, dass sie beliebig erweiterbar ist, wenn mehr als eine Komponente mit elektrischen Anschlüssen in dem elektrischen Bauteil vorzusehen ist und entsprechend viele Leitungsbereiche zwischen den Komponenten zur Verbindung der Anschlüsse der Komponenten untereinander und zur Verbindung der Anschlüsse zu Außenanschlüssen erforderlich werden. Ein weiterer Vorteil besteht darin, dass eine fokussierbare Energiequelle eingesetzt wird, um lokal in dem Leitungsbereich den Kunststoff in karbonisierte Leitungen umzusetzen.

Für transparente Kunststoffe hat die fokussierbare Energiequelle den Vorteil, dass Leitungen innerhalb des Kunststoffes im Fokuspunkt entstehen, wenn dieser von der Ausrichtmechanik in einer vorgegebenen Richtung zur Bildung von Leitungen geführt wird. Auch für nicht transparente Kunststoffe ist eine fokussierbare Energiequelle von Vorteil, einerseits um die lokale Ausdehnung der Leiterbahnen zu begrenzen und andererseits um eine Karbonisierung des Kunststoffs der Oberfläche bis zu einer durch den Fokus begrenzten Tiefe herzustellen.

Zusätzlich zu Gießform und fokussierbarerer Energiequelle weist die Vorrichtung eine Gießvorrichtung für Kunststoff auf. Diese Gießvorrichtung dient dem kontinuierlichen Auffüllen der Gießform mit Kunststoff. Während des Auffüllens einer dünnen Schicht werden mit Hilfe der fokussierbaren Energiequelle Verbindungsleitungen in den Leitungsbereichen des Kunststoffes hergestellt. Gleichzeitig und kontinuierlich wird die elektrische Anschlüsse aufweisende Komponente in Kunstharz eingebettet. Die fokussierbare Energiequelle kann ein Lasergerät mit fokussierbarem Laserstrahl, ein Ultraschallgerät mit fokussierbarer Ultraschallanregung, ein Mikrowellengerät mit fokussierbarer Mikrowellenanregung oder ein Elektronenstrahl- oder Ionenstrahlgerät sein.

Aufgrund der hohen Verfügbarkeit und der hohen Präzision werden Lasergeräte bevorzugt für die Vorrichtung zur Herstellung eines elektronischen Bauteils mit Leitungsbereichen beziehungsweise Leitungen aus karbonisiertem Kunststoff eingesetzt. Eine hohe Präzision liefern auch Elektronenstrahl- und Ionenstrahlanlagen. Ultraschallenergiequellen und Mikrowellengeräte sind besonders geeignet, wenn flächige oder schichtförmige karbonisierte Bereiche realisiert werden sollen, wie sie beispielsweise für passive Bauteile als Kondensatorplatten vorteilhaft sind.

In einer Ausführung der Vorrichtung ist es vorgesehen, zwei voneinander beabstandete Energiequellen über eine optische oder mechanische Ausrichtvorrichtung zu koppeln. Die Ausrichtvorrichtung ist dabei in der Lage, die Fokussierbereiche der fokussierbaren Energiequelle innerhalb der Leitungsbereiche derart zu überlagern, dass die Summe der Energieeinstrahlung im Fokusbereich den Kunststoff lokal karbonisiert, um Leitungen zu bilden. Jeder Einzelstrahl der Energiequellen ruft hingegen keine Veränderungen in dem Kunststoff hervor. Bei einem transparenten Kunststoff lassen sich somit innerhalb eines relativ dicken Leitungsbereiches sowohl horizontale als auch vertikale Leitungen und Leitungen unter jedem gewünschten räumlichen Winkel realisieren.

Bei nicht transparenten Kunststoffen kann jeweils auf einer Oberfläche des Kunststoffes die Überlagerung der Fokussierbereiche zu einer Verkohlung führen, so dass diese Vorrichtung sowohl für transparente Kunststoffe als auch für nicht transparente Kunststoffe zur Leitungsbildung geeignet ist. Die Steuerung der Ausrichtmechanik bzw. die Steuerung der Energiequellen und die Steuerung der Fokussierbereiche kann mittels eines Mikroprozessors kontrolliert und gesteuert werden.

Die Art der Energiequelle bestimmt auch die Art der Ausrichtvorrichtung. So sind Ionenstrahl- und Elektronenstrahlanlagen mit elektrooptischen Stellgliedern versehen, die ein Führen des Elektronen- beziehungsweise Ionenstrahls entlang zu bildender Leitungen erlauben. Bei Lasergeräten haben sich besonders optische Ablenkmittel, wie polygonale Drehspiegel und vorgeschaltete oder nachgeschaltete Linsensysteme bewährt, um die Ablenkung eines fokussierten Laserstrahls entlang von geplanten Leitungen in dem Leitungsbereich aus Kunststoff zu führen.

Ein Verfahren zur Herstellung eines elektronischen Bauteils mit mindestens einer elektrischen Komponente, die elektrische Anschlüsse aufweist, ist durch die nachfolgenden Verfahrensschritte gekennzeichnet. Zunächst wird die elektrische Komponente in einer Gießform für Kunststoff angeordnet. Anschließend wird in die Gießform ein Kunststoff eingebracht, um die elektrische Komponente wenigstens teilweise in dem Kunststoff einzubetten. Synchron erfolgt ein partielles Karbonisieren des Kunststoffes und/oder ein partielles Agglomerieren von Nanopartikeln in dem Kunststoff zu Leitungen in einem Leitungsbereich. Dazu erfolgt ein Einstrahlen von Energie eines fokussierten und geführten Strahls einer Energiequelle.

Ein derartiges Verfahren hat den Vorteil, dass zwischen Außenanschlüssen des herzustellenden elektronischen Bauteils und Anschlüssen der elektrischen Komponente gleichzeitig Verbindungsleitungen in dem Kunststoff hergestellt werden können. In vorteilhafter Weise können so vertikale Leitungen realisiert werden, indem die Kunststoffmasse in der Gießform allmählich ansteigt und gleichzeitig der Fokusbereich einer Energiequelle die Punkte ansteuert, an denen vertikale Leitungen entstehen sollen.

Wird der Kunststoff mit Nanopartikeln angereichert, so kann mit Hilfe der Energiequelle dafür gesorgt werden, dass die Nanopartikel zu Leitungen agglomerieren bis hin zum Sintern von Nanopartikeln zu Leitungen. Ferner ist es in vorteilhafter Weise möglich, zwischen Agglomeraten von Nanopartikeln, elektrisch leitende Brücken aus karbonisiertem Kunststoff herzustellen, so dass Leitungen entstehen, die sowohl karbonisierten Kunststoff als auch Nanopartikel aufweisen. In besonderer Weise lassen sich auch Nanopartikel durch Mikrowellen oder Ultraschallwellen derart anregen, dass sie flächige Leiterbahnen bilden, die als Kondensatorplatten für passive Bauelemente vorteilhaft einsetzbar sind.

Bei transparenten Kunststoffen können zwei beabstandete Energiequellen derart ausgerichtet werden, dass ihre Fokusbereiche zum Bilden von Leitungen überlagert werden.

Dabei entstehen durch Karbonisieren des Kunststoffes mit Hilfe der Überlagerung von Fokusbereichen zweier Energiequellen Leitungen innerhalb der transparenten Kunststoffschichten, Leitungen von Schicht zu Schicht und Leitungen nach außen zu Außenanschlüssen. An den Enden dieser nach außen gerichteten Anschlüsse kann der karbonisierte Kunststoff der Leitungen metallisiert werden. Andererseits ist es möglich, anstelle einer reinen Verkokung von Kunststoff eine Agglomeration von Nanopartikeln vorzusehen, um innerhalb und nach außen Leitungen aus metallischen Nanopartikeln zu realisieren. Zusätzlich kann die direkt angrenzende Harzschicht angehärtet oder ausgehärtet werden, um damit die "Rußleiterbahn" mechanisch zu stabilisieren. Abschließend kann nach außen durch eine Metallisierung des Rußes ein metallischer Außenanschluss des elektronischen Bauteils geschaffen werden. Somit ermöglicht die Erfindung ein beliebiges Anordnen von elektrischen Komponenten und Halbleiterchip in einem Kunstharz und eine dreidimensionale Verdrahtung der im Kunstharz angeordneten elektrischen Komponenten und Halbleiterchips. Für den Konstrukteur von komplexen Schaltungsmodulen ergibt sich der Vorteil einer völlig freien Gestaltung des Leitungsnetzes innerhalb des Moduls und einer völlig freien Anordnung der einzelnen elektrischen Komponenten mit entsprechenden elektrischen Anschlüssen.
- Figur 1: zeigt einen schematischen Querschnitt durch eine Vorrichtung zur Herstellung eines elektronischen Bauteils einer ersten Ausführungsform,
- Figur 2: zeigt einen schematischen Querschnitt durch eine Vorrichtung gemäß einer zweiten Ausführungsform,
- Figur 3: zeigt eine schematische Draufsicht auf einen Leitungsbereich in einer Vorrichtung einer dritten Ausführungsform,
- Figur 4: zeigt einen schematischen Querschnitt durch eine Vorrichtung zur Herstellung eines Moduls mit gestapelten elektronischen Komponenten einer vierten Ausführungsform.

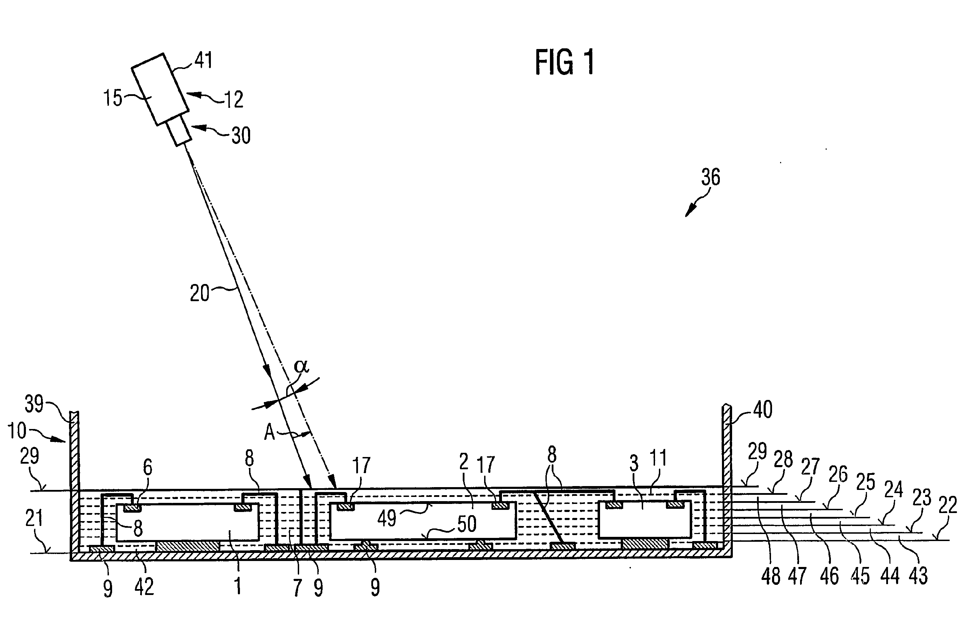

Figur 1 zeigt einen schematischen Querschnitt durch eine Vorrichtung 36 zur Herstellung eines elektronischen Bauteils einer ersten Ausführungsform. Die Vorrichtung 36 weist eine Gießform 10 auf, die als flache Wanne ausgebildet ist. Diese flache Wanne hat ein Bodenniveau 21, von dem aus die Gießform mit Kunstharz befüllt werden kann. Darüber hinaus weist die nach oben offene Gießform 10 Seitenwände 39 und 40 auf. Oberhalb der Gießform 10 ist eine Energiequelle 12 angeordnet, die einen fokussierbaren Strahl 20 liefern kann.

In dieser Ausführungsform der Vorrichtung 36 wird als Energiequelle 12 ein Lasergerät 15 eingesetzt, das ein Lasergehäuse 41 aufweist und eine an das Lasergehäuse 41 angeflanschte Ausrichtvorrichtung 30, mit dem der Laserstrahl über das gesamte Bodenniveau optisch abgelenkt werden kann, wobei eine in der Ausrichtvorrichtung 30 angeordnete Fokussiereinrichtung den Fokus des Lasergerätes an die Entfernung zwischen Ausrichtvorrichtung und Bodenniveau sowie den unterschiedlichen Gießniveaus 22 bis 29, die sich beim Füllen der Gießform 10 mit Kunstharz ergeben, angepasst werden kann. Ferner weist die Vorrichtung 36 eine nicht gezeigte Gießvorrichtung auf, die kontinuierlich die Gießform 10 mit Kunststoff auffüllt.

Diese nicht gezeigte Gießvorrichtung kann eine Kunststoffdispensionsvorrichtung oder eine Kunststoffsprüh- oder Kunststoffspritzvorrichtung sein, mit der der Kunststoff kontinuierlich in die Gießform 10 einbringbar ist. Auf das Bodenniveau sind unterschiedliche elektrische Komponenten 1, 2 und 3 einbringbar. In der in Figur 1 gezeigten Ausführungsform handelt es sich bei den elektrischen Komponenten um drei Halbleiterchips, die in einem Kunststoff 11 einzubetten sind und deren Kontaktflächen 17 auf den Oberseiten 49. Die Rückseiten 50 sollen dabei mit entsprechenden Außenkontakten 9 des zu bildenden elektronischen Bauteils verbunden werden.

Um ein Bauteil, wie es im Prinzip in der Figur 1 in der Gießform 10 gezeigt wird, herzustellen, wird zunächst auf dem Bodenniveau 21 der Gießform 10 eine erste Kunststoffschicht 42 aufgebracht, deren Dicke derartig bemessen ist, dass der fokussierte Laserstrahl 20 der Energiequelle 12 diese erste Kunststoffschicht 42 von dem ersten Gießniveau 22 bis zu dem Bodenniveau 21 durchkarbonisieren kann. Auch die übrigen Kunstharzschichten 43 bis 48 sind in ihrer Dicke so bemessen, dass sie jeweils durch den fokussierten Laserstrahl 20 durchgängig karbonisierbar sind.

Durch die Karbonisierung der ersten Kunststoffschicht auf dem Bodenniveau 21 der Gießform 10 werden in dieser Ausführungsform Außenkontakte 9 vorbereitet. Wie die Figur 1 zeigt, ist es möglich, völlig unterschiedlich große Flächen für diese Außenkontakte vorzusehen. Dieses hat besondere Vorzüge für den Schaltungsentwurf, so dass die Anordnung der Außenkontakte jeder Bauteilnorm angepasst werden kann.

Nach einem derartigen selektiven Karbonisieren der ersten Schicht, kann eine zweite Kunststoffschicht 43 bis zu dem Gießniveau 23 aufgebracht werden, das wiederum so gestaffelt ist, dass mit Hilfe des Laserstrahls 20 auch diese Schicht 43 mittels Karbonisierung durchkontaktiert werden kann. Dabei kann die Fläche der Außenkontakte der ersten Schicht 42 beibehalten werden oder bereits eine Verringerung der Flächengröße der Außenkontakte vorgenommen werden. Auf diesem Niveau 24 werden nach dem Karbonisieren der ersten beiden Schichten 42 und 43 die hier gezeigten elektrischen Komponenten 1, 2 und 3 mit ihren Rückseiten 50 aufgebracht.

Dabei entstehen großflächige Kontaktierungen zu den Außenkontakten 9 der Komponenten 1 und 3 oder, wie die Komponente 2 zeigt, können auch punktuelle Kontaktierungen zu den Außenkontakten realisiert werden. Durch Einstellen der Viskosität der zweiten Schicht 43 können praktisch die Rückseiten 50 auf dieser zweiten Kunststoffschicht 43 fixiert werden. Danach beginnt das Einbetten der Randseiten der Halbleiterchips in die Kunststoffmasse durch Aufbringen der Kunststoffschichten 44 bis 46. Nach dem Aufbringen jeder dieser Kunststoffschichten 44 bis 46 wird die Karbonisierung lokal und selektiv dort fortgesetzt, wo vertikale Leitungen oder Leitungen unter einem beliebigen Raumwinkel entstehen sollen, bis das Gießniveau 27 erreicht ist, das mit den aktiven Oberseiten 49 der Halbleiterchips eine gemeinsame Fläche aufweist.

Auf diese Fläche bzw. auf dem Niveau 27 wird eine weitere Schicht 47 aufgebracht, bei der nun nicht nur die vertikal oder unter einem Raumwinkeln angeordneten Leitungen fortgesetzt werden, sondern es wird auch der Kunststoff über den Kontaktflächen 17 der Halbleiterchips durchkarbonisiert. Danach wird die Kunststoffschicht 48 mit dem Gießniveau 29 aufgebracht. In der Kunststoffschicht 48 werden nun horizontale Verbindungsleitungen 8 zu den vertikalen bzw. zu dem unter einem Raumwinkel angeordneten Leitungen 8 und zu den Kontaktflächen 17 realisiert. Zum Schutz dieser karbonisierten Leitungen in der obersten Schicht 48 kann eine weitere nicht gezeigte Kunststofflage aufgebracht werden, oder es kann die Leitungsstruktur in dem Kunststoff weiter fortgesetzt und weitere elektronische Komponenten dreidimensional über dem Gießniveau 29 aufgebaut werden. Der Kunststoff 11, der in dieser Ausführungsform eingesetzt wird, ist entweder ein transparenter Kunststoff oder ein nicht durchsichtiger Kunststoff und kann mit Nanopartikeln angereichert sein. Da die Schichtfolge und die Schichtdicke der Kunststoffschichten 42 bis 48 auf eine Durchkarbonisierung eingestellt ist, kann für das in Figur 1 gezeigte Verfahren jeder karbonisierbare oder mit Nanopartikeln agglomerierbare Kunststoff unabhängig von seiner Transparenz eingesetzt werden.

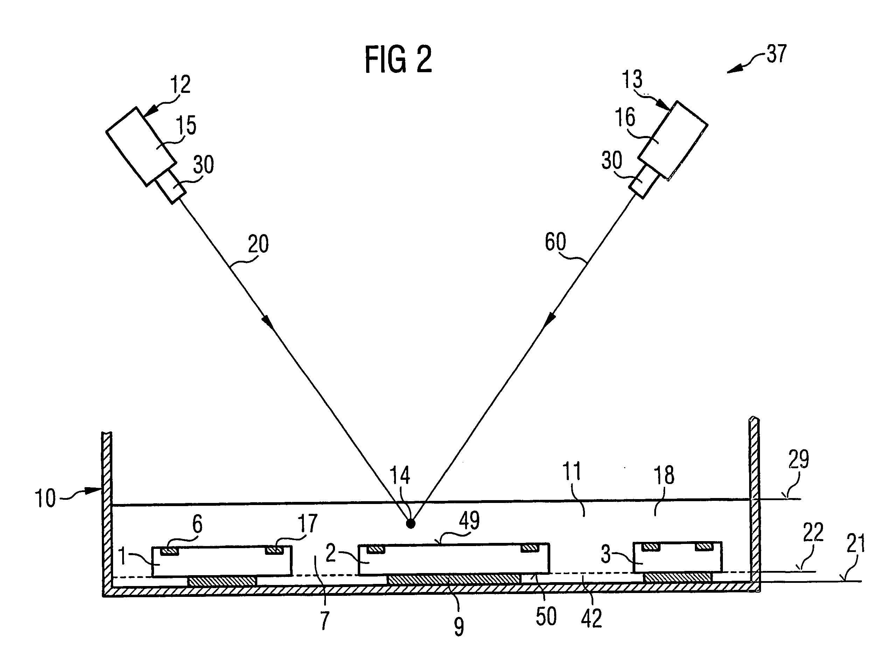

Figur 2 zeigt einen schematischen Querschnitt durch eine Vorrichtung 37 gemäß einer zweiten Ausführungsform. Komponenten mit gleichen Funktionen wie in Figur 1 werden mit gleichen Bezugszeichen gekennzeichnet und nicht extra erörtert. Diese Vorrichtung 37 der zweiten Ausführungsform ist insbesondere für ein Verdrahten von elektrischen Komponenten mit elektrischen Anschlüssen entwickelt worden, die in einem transparenten Kunststoff zu verpacken sind. Dazu weist die Vorrichtung 37 eine zweite Energiequelle 13 auf, die ebenfalls durch ein Lasergerät 16 zur Verfügung gestellt wird. Das Lasergerät 16 ist in dieser Ausführungsform der Erfindung genauso aufgebaut wie das Lasergerät 15. Beide Lasergeräte sind in einem Abstand über der nach oben offenen Gießform 10 angeordnet. Beide Laserstrahlen 20 und 60 überlappen sich in ihren Fokusbereichen 14, die so ausgerichtet sind, dass der gemeinsame Fokusbereich innerhalb des Leitungsbereichs des Kunststoffs, Leitungen aus karbonisiertem Kunststoff durch Verkohlung herstellen kann. Auch in diesem Beispiel werden die in der Gießform 10 positionierbaren elektrischen Komponenten durch Halbleiterchips realisiert. Diese Halbleiterchips weisen an ihren aktiven Oberseiten 49 Kontaktflächen 17 auf, die als elektrischer Anschlüsse 6 dienen.

Bei dieser Vorrichtung 37 ist es unter Verwendung von transparentem Kunststoff möglich, wesentlich dickere Schichten aus Kunststoff, als in der ersten Ausführungsform, vorzusehen. Die Kunststoffschicht 18 kann die elektrischen Komponenten bereits vollständig überdecken. Der einzelne fokussierte Laserstrahl 20 oder 60 der Lasergeräte 15 bzw. 16 liefert nicht genügend Energie, um ein Karbonisieren des transparenten Kunststoffes auszulösen. Jedoch im Brennpunkt 14 der beiden Lasergeräte 15 und 16 ist eine Karbonisierung möglich. Durch die Ausrichtvorrichtungen 30 der beiden Lasergeräte 15 und 16 wird eine dreidimensional Verdrahtung mittels karbonisierter Leitungen in der wesentlich dickeren Schicht 18 als die 42 bis 48 der Figur 1 realisiert.

Zunächst wird jedoch ähnlich wie in der ersten Ausführungsform eine dünne Kunststoffschicht 42 auf das Bodenniveau 21 aufgebracht bevor die Halbleiterchips mit ihren Rückseiten 50 positioniert werden und die Außenkontakte 9, die mit den Rückseiten 50 der Halbleiterchips kontaktiert werden sollen, werden in dieser Bodenschicht 42 vorbereitet. Anschließend kann die wannenförmige Gießform über das Niveau der aktiven Oberseiten 49 hinaus mit einer Kunststoffschicht 18 aufgefüllt werden. Nun steht der verbliebene nicht karbonisierte Kunststoff der Schicht 42 und der Schicht 18 zur Verfügung, um eine dreidimensionale Verdrahtung zwischen vorgesehenen zusätzlichen Außenkontakten für das elektronische Bauteil und den elektrischen Anschlüssen 6 in Form von Kontaktflächen 17 der Halbleiterchips zu verwirklichen.

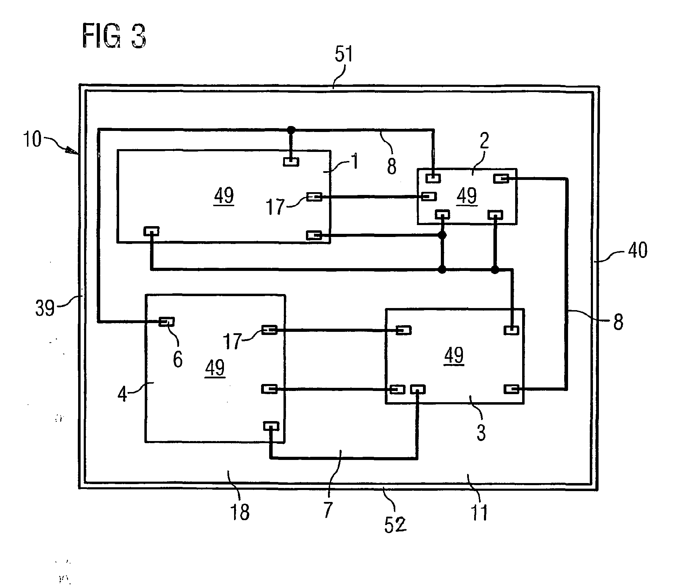

Figur 3 zeigt eine schematische Draufsicht auf einen Leitungsbereich 7 einer dritten Ausführungsform. Diese Draufsicht wird begrenzt durch die Gießform 10 mit ihren Seitenwänden 39, 40, 51 und 52. In dieser Ausführungsform sind vier elektrische Komponenten 1 bis 4 in Form von vier unterschiedlich großen Halbleiterchips in einer transparenten Kunststoffschicht 18 angeordnet, wobei ihre elektrischen Anschlüsse 6 in Form von Kontaktflächen 17 über karbonisierte Leitungen 8 untereinander verbunden sind. Sowohl die Anordnung der Anschlüsse 6 auf den aktiven Oberseiten 49 der Halbleiterchips, als auch die Führung der horizontalen Leitungen aus karbonisiertem Kunststoff oder aus agglomerierten Nanopartikeln oder aus einer Kombination von beidem sind völlig frei gestaltbar. Bei dieser Darstellung nach Figur 3 wird vorausgesetzt, dass der Kunststoff 11 transparent ist, so dass der Verlauf der Leitungen 8 sowie die Anordnung der vier Halbleiterchips und ihrer Kontaktflächen 17 sichtbar sind, obgleich sie in unterschiedlichen Niveaus angeordnet sind.

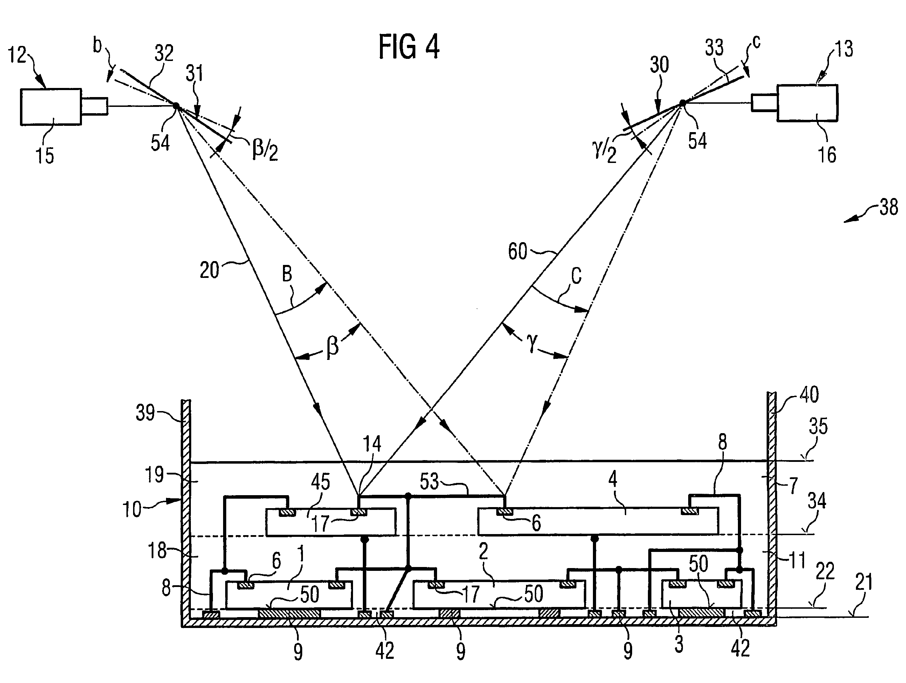

Figur 4 zeigt einen schematischen Querschnitt durch eine Vorrichtung 38 zur Herstellung eines Moduls mit gestapelten elektrischen Komponenten 1 bis 5 einer vierten Ausführungsform. Auch bei dieser Ausführungsform wurde ein transparenter Kunststoff 11 eingesetzt. Die Gießform 10 weist höhere Seitenwände 39 und 40 als die Ausführungsformen der vorhergehenden Figuren auf. Diese höheren Seitenwände 39 und 40 ermöglichen, einen Stapel von drei Kunststoffschichten 18, 19 und 42 herzustellen.

Auch für diese Vorrichtung 38 sind zwei Lasergeräte 15 und 16 vorgesehen. Diese Lasergeräte 15 und 16 unterscheiden sich von den Lasergeräten in den vorhergehenden Ausführungsformen dadurch, dass separate Ausrichtvorrichtungen 30 und 31 vorgesehen sind, die planare Kippspiegel 32 und 33 aufweisen. Diese Kippspiegel 32 und 33 werden um die Winkel β/2 bzw. γ/2 gekippt um das Drehen der Laserstrahlen 20 bzw. 60 um die Winkel β bzw. γ zu bewirken. Dabei beschreibt der gemeinsamen Fokuspunkt 14 eine Linie 53, die beispielsweise eine Verbindung zwischen einer der Kontaktflächen 17 der elektrischen Komponente 5 mit einem Anschluss 6 der Komponente 4 schafft.

Um ein derartig komplexes Bauelement in Form eines Moduls mit mehreren Komponenten, die teilweise übereinander gestapelt sind, herzustellen, wird, wie in den vorhergehenden Ausführungsformen zunächst auf dem Bodenniveau 21 der Gießform 10 eine dünne Schicht 42 aufgebracht. Diese wird an den Stellen, an denen Außenanschlüsse 9 vorzusehen sind, durchkarbonisiert. Anschließend wird die untere Lage aus elektrischen Komponenten 1, 2 und 3 auf das Niveau 22 der Schicht 42 aufgebracht und die Gießform 10 bis zu dem Gießniveau 34 mit transparentem Kunststoff 11 aufgefüllt.

Mit Hilfe der Lasergeräte 15 und 16 wird der Leitungsbereich 7 der Schicht 18 mit Leitungen versehen. Anschließend können auf das Niveau 34 an vorgesehenen Stellen weitere Komponenten 4, 5 in die Gießform 10 eingebracht werden und wiederum in einer dicken transparenten Kunststoffschicht 19 bis zu dem Gießniveau 35 eingebettet werden. Die Dicken der Schichten 18 und 19 liegen zwischen 500 µm und 2000 µm. Außerdem können beliebig viele Schichten 18 und 19 übereinander gestapelt werden, so dass ganze Modulblöcke preiswert herstellbar sind.

Nach dem Aufbringen der transparenten Schicht 19 werden dann die leitenden Verbindungen in Form von Leitungen 8 in den Leitungsbereich 7 der zweiten dicken transparenten Schicht 19 eingebracht. Die Leiterbahnen 8, die hier größtenteils in senkrechter oder horizontaler Richtung dargestellt sind, können auch in jedem beliebigen Raumwinkel verwirklicht werden, um optimale und kurze Verbindungsstrecken zu gewährleisten.

Um den Fokuspunkt 14 entlang der Leitung 53 zu führen werden die Laserstrahlen 20 und 60 synchron um die Winkel β bzw. γ geschwenkt. Dazu werden die Kippspiegel 32 und 33 um ihre Drehpunkte 54 in Richtung b bzw. c geschwenkt, während die Lasserstrahlen ihre Richtung in B bzw. C ändern.

## Patentansprüche

1. Verfahren zur Herstellung eines elektronischen Bauteils mit mindestens einer elektrischen Komponente (1 bis 5), die elektrische Anschlüsse (6) aufweist, wobei das Verfahren folgende Verfahrensschritte aufweist:
- Anordnen der elektrischen Komponente (1 bis 5) in einer Gießform (10) für Kunststoff (11),
- kontinuierliches Auffüllen der Gießform (10) aus einer Gießvorrichtung mit Kunststoff (11) zum wenigstens teilweisen Einbetten der elektrischen Komponente (1 bis 5),
- während des Auffüllens partielles Karbonisieren des Kunststoffes (11) und/oder partielles Agglomerieren von Nanopartikeln in dem Kunststoff (11) zu Leitungen (8) in einem Leitungsbereich (7) mittels Einstrahlen von Energie eines von einer Ausrichtvorrichtung fokussierten und geführten Strahls (20) einer Energiequelle.

2. Verfahren nach Anspruch 1,
**dadurch gekennzeichnet, dass** Leitungen (8) von den Anschlüssen (6) der Komponente (1 bis 5) zu Außenanschlüssen (6) des elektronischen Bauteils hergestellt werden.

3. Verfahren nach Anspruch 1 oder 2,
**dadurch gekennzeichnet, dass** zwei beabstandete Energiequellen (12, 13) derart ausgerichtet werden, dass ihre Fokusbereiche (14) zum Bilden von Leitungen (8) überlagert werden.

4. Verfahren nach einem der Ansprüche 1 bis 3,
**dadurch gekennzeichnet, dass** das Einbringen von Energie zur Bildung von Leitungen (8) mittels Mikrowellenanregung oder mittels elektromagnetischer Strahlung oder mittels Ultraschallstrahlung erfolgt.

## Claims

1. Method for the production of an electronic element comprising at least one electrical component (1 to 5) having electrical connections (6), the method having the following method steps:
- arrangement of the electrical component (1 to 5) in a casting mold (10) for plastic (11),
- continuous filling of the casting mold (10) with plastic (11) from a casting device for at least partially embedding the electrical component (1 to 5),
- during the filling, partial carbonization of the plastic (11) and/or partial agglomeration of nanoparticles in the plastic (11) to form lines (8) in a line region (7) by means of radiating in energy of a beam (20) from an energy source, which beam is focused and guided by an orienting device.

2. Method according to Claim 1,
**characterized in that**
lines (8) are produced from the connections (6) of the component (1 to 5) to external connections (6) of the electronic element.

3. Method according to one of Claim 1 or 2,
**characterized in that**
two spaced-apart energy sources (12, 13) are oriented in such a way that their focus regions (14) are superimposed for the formation of lines (8).

4. Method according to one of Claims 1 to 3,
**characterized in that**
the introduction of energy for the formation of lines (8) is effected by means of microwave excitation or by means of electromagnetic radiation or by means of ultrasonic radiation.

## Revendications

1. Procédé de fabrication d'un élément électronique ayant au moins un composant (1 à 5) électrique, qui a des bornes (6) électriques, le procédé ayant les stades de procédé suivants :
- on met le composant (1 à 5) électrique dans un moule (10) de coulée de matière plastique (11),
- on remplit continuellement le moule (10) de coulée de matière plastique (11) provenant d'un dispositif de coulée pour enrober au moins en partie le composant (1 à 5) électrique,
- pendant le remplissage, on carbonise partiellement la matière plastique (11) et/ou on agglomère partiellement des nanoparticules dans la matière plastique (11) en des conducteurs (8) dans une zone (7) de conducteurs par rayonnement d'énergie d'un faisceau (20) d'une source d'énergie, focalisé et guidé par un dispositif d'orientation.

2. Procédé suivant la revendication 1,
**caractérisé en ce que**
on fabrique des conducteurs (8) allant des bornes (6) du composant (1 à 5) à des bornes (6) extérieures de l'élément électronique.

3. Procédé suivant la revendication 1 ou 2,
**caractérisé en ce que** on oriente deux sources (12, 13) d'énergie à distance l'une de l'autre, de manière à ce que leurs régions (14) de foyer soient superposées pour la formation de conducteurs.

4. Procédé suivant l'une des revendications 1 à 3,
**caractérisé en ce que**
l'apport d'énergie pour la formation de conducteurs (8) s'effectue au moyen d'une excitation micro-onde ou au moyen d'un rayonnement électromagnétique ou au moyen d'un rayonnement ultrason.
